(19) Europäisches Patentamt
European Patent Office
Office européen des brevets

(11) EP 4 617 323 A1

(12) **EUROPEAN PATENT APPLICATION**
published in accordance with Art. 153(4) EPC

(43) Date of publication:
**17.09.2025 Bulletin 2025/38**

(21) Application number: **23888596.6**

(22) Date of filing: **01.11.2023**

(51) International Patent Classification (IPC):
***C08L 101/00*** *(2006.01)* ***B22F 1/00*** *(2022.01)*
***B22F 1/052*** *(2022.01)* ***B22F 3/00*** *(2021.01)*
***C01B 33/06*** *(2006.01)* ***C08J 5/18*** *(2006.01)*
***C08K 3/08*** *(2006.01)* ***C08K 5/521*** *(2006.01)*
***C08K 5/524*** *(2006.01)* ***C22C 38/00*** *(2006.01)*

(52) Cooperative Patent Classification (CPC):
**B22F 1/00; B22F 1/052; B22F 3/00; C01B 33/06; C08J 5/18; C08K 3/08; C08K 5/521; C08K 5/524; C08L 101/00; C22C 38/00**

(86) International application number:
**PCT/JP2023/039490**

(87) International publication number:
**WO 2024/101248 (16.05.2024 Gazette 2024/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.11.2022 JP 2022178676**

(71) Applicants:
- **TOYOBO MC Corporation**
  **Osaka 530-0001 (JP)**
- **Daido Steel Co., Ltd.**
  **Nagoya-shi**
  **Aichi 461-8581 (JP)**

(72) Inventors:
- **KAMIYA, Motonobu**
  **Otsu-shi, Shiga 520-0292 (JP)**
- **MAEDA, Maki**
  **Otsu-shi, Shiga 520-0292 (JP)**
- **SHIMIZU, Takahiro**
  **Otsu-shi, Shiga 520-0292 (JP)**
- **HORI, Yusaku**
  **Otsu-shi, Shiga 520-0292 (JP)**
- **SAITO, Akihiko**
  **Nagoya-shi, Aichi 457-8545 (JP)**
- **NAKAMA, Yu**
  **Nagoya-shi, Aichi 457-8545 (JP)**

(74) Representative: **Vossius & Partner Patentanwälte Rechtsanwälte mbB**
**Siebertstrasse 3**
**81675 München (DE)**

# (54) ELECTROMAGNETIC WAVE-ABSORBING COMPOSITION COMPRISING THERMOPLASTIC RESIN OR THERMOPLASTIC ELASTOMER, AND MOLDED ARTICLE COMPRISING SAME

(57) The present invention aims to provide an electromagnetic wave-absorbing composition comprising a thermoplastic resin or a thermoplastic elastomer, exhibiting electromagnetic wave absorption performance, and suppressing an increase in fluidity when heated. The composition of the present invention comprises a component (A) that is at least one selected from a thermoplastic resin and a thermoplastic elastomer and a component (B) that is a Fe-Cr-Si-based soft-magnetic metal powder at a mass ratio (component (A)/component (B)) in a range of 5/95 to 80/20, further comprises a component (C) that is at least one selected from a phosphite-based compound and a phosphate-based compound in an amount of 0.02 to 1.4 parts by mass relative to 100 parts by mass in total of the component (A) and the component (B), and has an electromagnetic wave absorption energy P at 79 GHz of 5 kW/$m^3$ or more.

EP 4 617 323 A1

## Description

### TECHNICAL FIELD

The present invention relates to an electromagnetic wave-absorbing composition capable of suppressing an increase in fluidity when heated.

### BACKGROUND ART

In a high frequency communication device equipped with a processing circuit that processes an input signal and outputs a resulting signal, the processing circuit is typically housed in a metal enclosure to prevent the influence of external electromagnetic waves on signals being processed and to suppress the leakage of electromagnetic waves from the device. In such cases, electromagnetic wave propagation and resonance within the enclosure can lead to coupling (electromagnetic field coupling) between the input and output signals, posing a problem. The metal material of the enclosure walls contributes to this coupling. This issue has become more pronounced as communication frequencies increase.

In high-frequency communication devices, it is commonly known to attach a sheet-like electromagnetic wave absorber to the inner surface of the metal enclosure as a means of reducing coupling between signals in circuits, such as between an input signal and an output signal.

Patent Document 1 discloses an example of an electromagnetic wave absorber obtained by mixing a powder of Fe-7Cr-9Al alloy, which is soft magnetic metal, into chlorinated polyethylene rubber at 15 to 45 vol% and rolling a resulting mixture into a sheet having a thickness of 0.5 to 1.5 mm, and discloses that it has an effect of preventing coupling between the input side and the output side in the frequency range of 9 to 12 GHz.

Patent Document 2 discloses an electromagnetic wave absorber in the frequency range of 1 to 100 GHz, which is a sheet obtained by mixing Fe-Cr-Si-based alloy powder into acrylic resin or silicone resin. It further discloses that the absorber exhibits good electromagnetic wave attenuation characteristics even at higher frequencies.

As described above, in electromagnetic wave absorbers used in communication devices, it is common to attach a sheet to the necessary location, such as the enclosure. However, the attachment process involves multiple steps, including applying adhesive and affixing the sheet to the metal enclosure, making it cumbersome. Therefore, there is a demand for eliminating the use of sheets, such as by integrating an electromagnetic wave-absorbing resin material with the metal enclosure through insert molding or by replacing the metal enclosure itself with a resin material that has electromagnetic wave absorption properties.

Patent Document 3 mentions an example of an electromagnetic wave-absorbing resin for injection molding, and discloses that Fe-Si-Al alloy powder having a specific median diameter and aspect ratio is contained in polyamide resin to impart shield properties of magnetic waves in the frequency range of 0.1 to 100 MHz.

### CITATION LIST

### PATENT DOCUMENT

Patent Document 1: JP-A-2002-164687
Patent Document 2: JP-B2-6859652
Patent Document 3: JP-A-2012-151205

### SUMMARY OF THE INVENTION

### PROBLEMS TO BE SOLVED BY THE INVENTION

However, it has been found that a composition like the one disclosed in Patent Document 3, which contains a thermoplastic resin or a thermoplastic elastomer and a soft-magnetic metal powder, exhibits increased fluidity when heated. As the fluidity increases, overfilling occurs during molding, which may have adverse effect on the mass-productivity of molded articles obtained.

The present invention aims to provide an electromagnetic wave-absorbing composition comprising a thermoplastic resin or a thermoplastic elastomer, exhibiting electromagnetic wave absorption performance, and suppressing an increase in fluidity when heated.

SOLUTION TO THE PROBLEMS

The inventors made intensive studies to solve the above-mentioned problems. As a result, the inventors have found that when a Fe-Cr-Si-based soft-magnetic metal powder is contained in a thermoplastic resin or a thermoplastic elastomer to produce a composition, a predetermined amount of at least one selected from a phosphite-based compound and a phosphate-based compound is further contained therein, whereby an increase in fluidity when the composition is heated can be suppressed while maintaining the electromagnetic wave absorption performance. The present invention has been completed based on this finding. More specifically, the present invention provides the following.

[1] An electromagnetic wave-absorbing composition comprising a component (A) that is at least one selected from a thermoplastic resin and a thermoplastic elastomer and a component (B) that is a Fe-Cr-Si-based soft-magnetic metal powder at a mass ratio (component (A)/component (B)) in a range of 5/95 to 80/20, and further comprising a component (C) that is at least one selected from a phosphite-based compound and a phosphate-based compound in an amount of 0.02 to 1.4 parts by mass relative to 100 parts by mass in total of the component (A) and the component (B),

wherein the electromagnetic wave-absorbing composition has an electromagnetic wave absorption energy P, shown in the following equation (1), at 79 GHz of 5 kW/m$^3$ or more:

[Mathematical 1]

$$P = \pi f \mu_0 \mu_r{}'' |H|^2 + \pi f \varepsilon_0 \varepsilon_r{}'' |E|^2 + \frac{1}{2\rho}|E|^2 \qquad (1)$$

wherein P represents an electromagnetic wave absorption energy (W/m$^3$), $\mu_0$ represents a magnetic permeability of vacuum (H/m), $\mu_r$" represents a loss term of a relative complex permeability, $\varepsilon_0$ represents a permittivity of vacuum (F/m), $\varepsilon_r$" represents a loss term of a relative complex permittivity, p represents a resistivity ($\Omega$m), H represents a magnetic field strength (A/m), E represents an electric field strength (V/m), and f represents a frequency (Hz).

[2] The electromagnetic wave-absorbing composition according to [1],

wherein $\Delta$MFR determined by the following formula as measured in accordance with ISO 1133 is 50 g/10 min or less:

$\Delta$MFR = (MFR in retention for 20 minutes) - (MFR in retention for 5 minutes)

wherein the MFR in retention for 20 minutes is a melt flow rate measured with a preheating time of 20 minutes, and the MFR in retention for 5 minutes is a melt flow rate measured with a preheating time of 5 minutes; and the melt flow rate is measured under a load of 2160 g and at a temperature higher by 25°C than a melting point of the component (A).

[3] The electromagnetic wave-absorbing composition according to [1] or [2], wherein the component (A) comprises at least one selected from the group consisting of a polyester-based resin, a polyester elastomer, a polycarbonate-based resin, a polyamide-based resin, a polyphenylene sulfide-based resin, and a polyolefin-based resin.

[4] The electromagnetic wave-absorbing composition according to any one of [1] to [3], wherein the component (B) contains 1.0 to 21.0% by mass of Cr, 0.5 to 10.0% by mass of Si, and 0 to 3.0% by mass of Mo with the balance being Fe and impurities.

[5] The electromagnetic wave-absorbing composition according to any one of [1] to [4], wherein the component (B) has an average particle diameter D50 of 3 to 15 $\mu$m.

[6] A molded article formed from the electromagnetic wave-absorbing composition according to any one of [1] to [5].

ADVANTAGEOUS EFFECTS OF THE INVENTION

According to the present invention, by mixing a specific amount of a component (C) that is at least one selected from a phosphite-based compound and a phosphate-based compound with a component (A) that is at least one selected from a thermoplastic resin and a thermoplastic elastomer and a component (B) that is a Fe-Cr-Si-based soft-magnetic metal powder, it is possible to obtain a composition that exhibits excellent electromagnetic wave absorption performance while suppressing an increase in fluidity when heated.

DESCRIPTION OF EMBODIMENTS

The embodiments of the present invention will be described in detail below. However, the present invention is not limited to the following embodiments, and modifications may be made as appropriate within the scope of the invention's objectives. When there are overlapping explanations, the corresponding descriptions may be omitted as necessary, but such omissions do not limit the gist of the invention.

[Component (A)]

In the electromagnetic wave-absorbing composition of the present invention, the component (A) used as a base component (matrix component) is at least one selected from a thermoplastic resin and a thermoplastic elastomer.

The thermoplastic resin is not particularly limited, but typical examples thereof include a polyester-based resin, a polycarbonate-based resin, a polyamide-based resin, a polyphenylene sulfide-based resin, and a polyolefin-based resin. These thermoplastic resins may be used alone or in combination of two or more.

The thermoplastic elastomer is not particularly limited, but typical examples thereof include a polyester elastomer.

The component (A) may be used alone or in combination of two or more kinds.

Among the examples given as the component (A), particularly, a resin and/or an elastomer having an ester skeleton and/or an amide skeleton in repeating portions of its main chain (hereinafter referred to as an ester-amide-based resin and/or elastomer) such as a polyester-based resin, a polyester elastomer, a polycarbonate-based resin, and a polyamide-based resin are preferable, and a resin and/or an elastomer having an ester skeleton in repeating portions of its main chain (hereinafter referred to as an ester-based resin and/or elastomer) are more preferable. When the component (A) (particularly, an ester-amide-based resin and/or elastomer) is melt-kneaded with a soft-magnetic metal powder as the component (B), the fluidity of the resulting mixture is easily increased by heating. However, in the present invention, the coexistence of at least one selected from a phosphite-based compound and a phosphate-based compound, which is the component (C), with the component (A) and the component (B) permits suppression of the increase in fluidity.

The component (A) is preferably an ester-amide-based resin and/or elastomer, more preferably at least one selected from the group consisting of a polyester-based resin (excluding a liquid crystal polyester-based resin), a polyamide-based resin, and a polyester elastomer, further preferably at least one selected from the group consisting of a polyester-based resin (excluding a liquid crystal polyester-based resin) and a polyester elastomer, and particularly preferably a polyester-based resin (excluding a liquid crystal polyester-based resin). A polyester-based resin (excluding a liquid crystal polyester-based resin) and a polyester elastomer have low water absorbency and are useful for improving the dimensional stability of a molded article obtained.

The polyester-based resin is preferably an aromatic polyester resin having an aromatic dicarboxylic acid unit and a diol unit as constituent units.

The aromatic dicarboxylic acid serving as the constituent units is not particularly limited, but specific examples thereof include benzenedicarboxylic acid such as terephthalic acid, isophthalic acid, and orthophthalic acid; naphthalenedicarboxylic acid such as 2,6-naphthalenedicarboxylic acid and 1,5-naphthalenedicarboxylic acid; a compound having two carboxyphenyl groups, such as 1,2-bis(phenoxy)ethane-p,p'-dicarboxylic acid and diphenyl-p,p-dicarboxylic acid; and functional derivatives thereof. These aromatic dicarboxylic acids may be used alone or in combination of two or more.

Preferred examples of the aromatic dicarboxylic acid serving as the constituent units include terephthalic acid, isophthalic acid, 2,6-naphthalenedicarboxylic acid, and diphenyl-p,p-dicarboxylic acid. These compounds as the constituent units tend to increase the crystallization rate and improve moldability. Particularly preferred examples thereof include benzenedicarboxylic acid such as terephthalic acid and isophthalic acid, and naphthalenedicarboxylic acid such as 2,6-naphthalenedicarboxylic acid.

The aromatic dicarboxylic acid unit is introduced, for example, by ester synthesis using an aromatic dicarboxylic acid, an aromatic dicarboxylic acid ester, or a salt thereof as a raw material. Examples of the aromatic dicarboxylic acid ester to be used as a raw material include a monoalkyl ester of an aromatic dicarboxylic acid, and a dialkyl ester of an aromatic dicarboxylic acid, and a dialkyl ester of an aromatic dicarboxylic acid is preferred. Preferred examples of the raw material include terephthalic acid, terephthalic acid dimethyl ester, isophthalic acid, isophthalic acid dimethyl ester, 2,6-naphthalenedicarboxylic acid, and 2,6-naphthalenedicarboxylic acid dimethyl ester.

Furthermore, in the aromatic polyester resin, a part of the aromatic dicarboxylic acid unit can be replaced with a dicarboxylic acid unit other than the aromatic dicarboxylic acid unit (hereinafter referred to as other dicarboxylic acid unit). Examples of the dicarboxylic acid other than the aromatic dicarboxylic acid serving as the other dicarboxylic acid unit include a saturated or unsaturated aliphatic dicarboxylic acid, a functional derivative of the aliphatic dicarboxylic acid, an alicyclic dicarboxylic acid, and a functional derivative of the alicyclic dicarboxylic acid. Examples of the aliphatic dicarboxylic acid include adipic acid, sebacic acid, succinic acid, glutaric acid, 1,10-decanedicarboxylic acid, and dimer

acid. Examples of the alicyclic dicarboxylic acid include hexahydroterephthalic acid, hexahydroisophthalic acid, and cyclohexanedicarboxylic acid. The content of the other dicarboxylic acid unit is preferably less than 50 mol%, more preferably less than 40 mol%, and further preferably less than 30 mol%, in the total of the aromatic dicarboxylic acid unit and the other dicarboxylic acid unit (all dicarboxylic acid units). When the content is less than 50 mol%, the crystallinity of the polyester-based resin is good, and the moldability and heat resistance tend to become better.

The diol (unit) constituting the aromatic polyester is not particularly limited, but specific examples thereof include an aliphatic glycol such as alkylene glycol (for example, ethylene glycol, 1,3-propylene glycol, 1,4-butanediol, and 1,6-hexanediol); an alicyclic glycol such as 1,4-cyclohexanedimethanol and 1,4-cyclohexanediol; and an aromatic diol such as bisphenol A, hydroquinone, and 2,2-bis(4-β-hydroxyethoxyphenyl)propane. These diols (units) may be used alone or in combination of two or more.

The diol (unit) is preferably at least one selected from the group consisting of the aliphatic glycol and the alicyclic glycol, and more preferably an alkylene glycol having 2 to 8 carbon atoms. More specifically, the diol (unit) is at least one selected from the group consisting of ethylene glycol, 1,3-propylene glycol, 1,4-butanediol, 1,6-hexanediol, and 1,4-cyclohexanedimethanol, and more preferably at least one selected from ethylene glycol and 1,4-butanediol.

Specific examples of the aromatic polyester resin include polyethylene terephthalate, polypropylene terephthalate, polybutylene terephthalate, polycyclohexanedimethylene terephthalate, polyhexylene terephthalate, polyethylene naphthalate, polypropylene naphthalate, polybutylene naphthalate, a polyethylene isophthalate/terephthalate copolymer, a polypropylene isophthalate/terephthalate copolymer, a polybutylene isophthalate/terephthalate copolymer, a polyethylene terephthalate/naphthalate copolymer, a polypropylene terephthalate/naphthalate copolymer, a polybutylene terephthalate/naphthalate copolymer, a polybutylene terephthalate/decanedicarboxylate copolymer, a polyethylene terephthalate/cyclohexanedimethylene terephthalate copolymer, a polyethylene terephthalate/succinate copolymer, a polypropylene terephthalate/succinate copolymer, a polybutylene terephthalate/succinate copolymer, a polyethylene terephthalate/adipate copolymer, a polypropylene terephthalate/adipate copolymer, a polybutylene terephthalate/adipate copolymer, a polyethylene terephthalate/sebacate copolymer, a polypropylene terephthalate/sebacate copolymer, a polybutylene terephthalate/sebacate copolymer, a polyethylene terephthalate/isophthalate/adipate copolymer, a polypropylene terephthalate/isophthalate/adipate copolymer, a polybutylene terephthalate/isophthalate/succinate copolymer, a polybutylene terephthalate/isophthalate/adipate copolymer, a polybutylene terephthalate/isophthalate/sebacate copolymer, a bisphenol Alterephthalic acid polymer, a bisphenol A/isophthalic acid polymer, and a bisphenol A/terephthalic acid/isophthalic acid copolymer.

Furthermore, examples of the polyester-based resin also include a liquid crystal polyester-based resin. Examples of the liquid crystal polyester-based resin include a p-hydroxybenzoic acid/ethylene glycol/terephthalic acid copolymer, a hydroxynaphthoic acid/p-hydroxybenzoic acid copolymer, and a biphenol/benzoic acid/p-hydroxybenzoic acid copolymer.

The polyester-based resin is preferably an aromatic polyester resin other than a liquid crystal polyester-based resin. Among aromatic polyester resins other than a liquid crystal polyester-based resin, a polymer having an aromatic dicarboxylic acid and an alkylene glycol as constituent units is preferable, a polymer having an aromatic dicarboxylic acid and an alkylene glycol having 2 to 8 carbon atoms as constituent units is more preferable, and a polymer having terephthalic acid and an alkylene glycol having 2 to 8 carbon atoms as constituent units is further preferable. From the viewpoint of heat resistance and moldability, at least one selected from the group consisting of polyethylene terephthalate (PET) and polybutylene terephthalate (PBT) is preferable, and polybutylene terephthalate (PBT) is particularly preferable.

The polyester-based resin has an intrinsic viscosity of preferably 0.5 to 1.8 dl/g, and more preferably 0.6 to 1.5 dl/g. When the polyester-based resin has an intrinsic viscosity of the predetermined value or more, the durability can be increased, and when the polyester-based resin has an intrinsic viscosity of the predetermined value or less, the processability in injection molding and the like can be improved.

The polyester elastomer is preferably a polyester elastomer in which a hard segment composed of a polyester having an aromatic dicarboxylic acid and an aliphatic glycol and/or alicyclic glycol as constituent units and at least one soft segment selected from an aliphatic polyether, an aliphatic polyester, and an aliphatic polycarbonate are bonded to each other.

Examples of the aromatic dicarboxylic acid constituting the hard segment polyester include the aromatic dicarboxylic acid units mentioned as examples of the above-mentioned aromatic polyester resin, and the preferred embodiments thereof are also the same. As with the above-mentioned aromatic polyester resin, a dicarboxylic acid other than the aromatic dicarboxylic acid may be contained as constituent units, and the preferred embodiments thereof are also the same as those mentioned above.

Examples of the aliphatic glycol and the alicyclic glycol constituting the hard segment polyester include the aliphatic glycols and the alicyclic glycols mentioned as examples of the above-mentioned aromatic polyester resin, and the preferred embodiments thereof are also the same.

The hard segment is preferably a polyester having an aromatic dicarboxylic acid and an alkylene glycol having 2 to 8 carbon atoms as constituent units, and more preferably a polyester having terephthalic acid and an alkylene glycol

having 2 to 8 carbon atoms as constituent units. From the viewpoint of heat resistance and moldability, at least one selected from the group consisting of polyethylene terephthalate (PET) and polybutylene terephthalate (PBT) is preferable, and polybutylene terephthalate (PBT) is particularly preferable.

When an aromatic polyester suitable for use as the polyester constituting the hard segment is produced beforehand and then copolymerized with a soft segment component, the aromatic polyester can be easily prepared in accordance with a typical polyester production method. Such a polyester preferably has a number average molecular weight of 10000 to 40000.

Examples of the aliphatic polyether constituting the soft segment of the polyester elastomer include a polyether having one or more alkanediols having 2 to 10 carbon atoms as constituent units, such as polyoxyethylene glycol, polyoxypropylene glycol, polyoxytetramethylene glycol, polyoxyhexamethylene glycol, polyoxytrimethylene glycol, a copolymer of ethylene oxide with propylene oxide, an ethylene oxide adduct of polyoxyethylene glycol, and a copolymer of ethylene oxide with tetrahydrofuran. The aliphatic polyether has a number average molecular weight of, for example, 300 to 5000, preferably 500 to 4000, and more preferably 700 to 2500.

Examples of the aliphatic polyester constituting the soft segment include an aliphatic polyester having ester groups and alkylene groups having 2 to 12 carbon atoms that are repeated, such as poly(ε-caprolactone), polyenantholactone, polycaprylolactone, and polybutylene adipate. The aliphatic polyester has a number average molecular weight of, for example, 300 to 5000, preferably 500 to 4000, and more preferably 700 to 2000.

The aliphatic polycarbonate constituting the soft segment may be a resin composed of a carbonic acid unit and an aliphatic diol unit, and the aliphatic diol is preferably an aliphatic diol having 2 to 12 carbon atoms. Examples of the aliphatic diol include ethylene glycol, 1,3-propylene glycol, 1,4-butanediol, 1,5-pentanediol, 1,6-hexanediol, 1,8-octanediol, 2,2-dimethyl-1,3-propanediol, 3-methyl-1,5-pentanediol, 2,4-diethyl-1,5-pentanediol, 1,9-nonanediol, and 2-methyl-1,8-octanediol. In particular, an aliphatic diol having 5 to 12 carbon atoms is preferable from the viewpoint of flexibility and low-temperature characteristics of a polyester elastomer to be obtained. These components may be used alone or in combination of two or more as needed. The aliphatic polycarbonate has a number average molecular weight of, for example, 300 to 15000, and preferably 500 to 13000.

In the polyester elastomer, the composition ratio of the hard segment to the soft segment (hard segment/soft segment) is preferably 40/60 to 95/5, more preferably 50/50 to 95/5, and further preferably 55/45 to 90/10, on a mass basis.

The polyester elastomer has a reduced viscosity of preferably 0.5 dl/g or more and 3.5 dl/g or less, more preferably 1.0 dl/g or more and 3.0 dl/g or less, and further preferably 1.1 dl/g or more and 2.8 dl/g or less. When the polyester elastomer has a reduced viscosity of the predetermined value or more, the durability can be improved, and when the polyester elastomer has a reduced viscosity of the predetermined value or less, the processability in injection molding and the like can be improved.

The polyester elastomer preferably has an acid value of 5 to 200 eq/ton, and more preferably 10 to 80 eq/ton.

The polyester elastomer preferably has a Shore D hardness of 25 to 75, and more preferably 25 to 65.

The polycarbonate-based resin is not particularly limited as long as it is a resin composed of a carbonic acid unit and a diol unit, and examples thereof include an aromatic polycarbonate resin having a carbonic acid unit and an aromatic diol unit as constituent units, an aliphatic polycarbonate resin having a carbonic acid unit and an aliphatic diol unit as constituent units, and an aromatic-aliphatic polycarbonate resin having a carbonic acid unit, an aromatic diol unit and an aliphatic diol unit as constituent units.

Examples of the aromatic diol constituting the polycarbonate-based resin include the same compounds as the aromatic diols mentioned as the constituent units of the polyester-based resin.

Examples of the aliphatic diol constituting the polycarbonate-based resin include the same compounds as the aliphatic diols mentioned as the constituent units of the aliphatic polycarbonate constituting the soft segment of the polyester elastomer.

The polyamide-based resin is a resin obtained from (i) an amino acid, (ii) a lactam, or (iii) a diamine and a dicarboxylic acid, as main raw materials. The polyamide-based resin can be produced by polycondensation of an amino acid, by ring-opening polymerization of a lactam, or by polycondensation of a diamine and a dicarboxylic acid. The content of the amino acid, lactam, diamine and dicarboxylic acid in the raw materials constituting the polyamide resin is preferably 50 mol% or more, more preferably 70 mol% or more, and further preferably 85 mol% or more.

Examples of the amino acid include an amino aliphatic carboxylic acid having about 4 to 15 carbon atoms such as 6-aminocaproic acid, 11-aminoundecanoic acid, and 12-aminododecanoic acid; and an amino aromatic carboxylic acid such as p-aminomethylbenzoic acid.

Examples of the lactam include an aliphatic lactam having about 5 to 15 carbon atoms such as ε-caprolactam and ω-laurolactam.

Examples of the diamine include tetramethylenediamine, hexamethylenediamine, nonamethylenediamine, decamethylenediamine, undecamethylenediamine, dodecamethylenediamine, 2,2,4-/2,4,4-trimethylhexamethylenediamine, 5-methylnonamethylenediamine, 2,4-dimethyloctamethylenediamine, m-xylylenediamine, p-xylylenediamine, 1,3-bis(aminomethyl)cyclohexane, 1-amino-3-aminomethyl-3,5,5-trimethylcyclohexane, 3,8-bis(aminomethyl)tricyclodecane, bis(4-aminocyclohexyl)methane, bis(3-methyl-4-aminocyclohexyl)methane, 2,2-bis(4-aminocyclohexyl)propane, and bis(aminopropyl)piperazine.

Examples of the dicarboxylic acid include adipic acid, suberic acid, azelaic acid, sebacic acid, dodecanedioic acid, terephthalic acid, isophthalic acid, naphthalenedicarboxylic acid, 2-chloroterephthalic acid, 2-methylterephthalic acid, 5-methylisophthalic acid, sodium 5-sulfoisophthalate, hexahydroterephthalic acid, hexahydroisophthalic acid, and diglycolic acid.

Specific examples of the polyamide-based resin include polyamide 6, polyamide 66, polyamide 46, polyamide 11, polyamide 12, polyamide 610, polyamide 69, polyamide 6T, polyamide 9T, polyamide MXD6, a polyamide 6/66 copolymer, a polyamide 6/610 copolymer, a polyamide 6/6T copolymer, a polyamide 6/66/610 copolymer, a polyamide 6/12 copolymer, a polyamide 6T/12 copolymer, a polyamide 6T/66 copolymer, a polyamide 6/6I copolymer, a polyamide 66/6I/6 copolymer, a polyamide 6T/6I copolymer, a polyamide 6T/6I/66 copolymer, a polyamide 6/66/610/12 copolymer, and a polyamide 6T/M-5T copolymer. Among these, from the viewpoint of chemical resistance and impact-resistance of a molded article obtained and flowability, at least one selected from the group consisting of polyamide 6, polyamide 66, polyamide 12, and a copolymer containing at least one of these as a main component are preferable, at least one selected from the group consisting of polyamide 6 and a copolymer containing polyamide 6 as a main component are more preferable. In this specification, a "copolymer containing A as a main component" indicates a copolymer having a structure derived from A at a ratio of preferably 50 mol% or more, more preferably 70 mol% or more, and further preferably 85 mol% or more.

The relative viscosity of the polyamide-based resin measured in a 98% sulfuric acid solution (polyamide-based resin concentration: 1 g/dl, temperature: 20°C) is preferably 1.5 to 3.5, more preferably 2.0 to 3.0, and further preferably 2.2 to 2.8.

The polyphenylene sulfide-based resin is not particularly limited, and any commonly used polyphenylene sulfide-based resin can be used. Specific examples thereof include poly(p-phenylene sulfide), polyphenylene sulfide sulfone, polyphenylene sulfide ketone, and polyphenylene sulfide ether.

Specific examples of the polyolefin-based resin include a homopolymer or copolymer containing repeating units generated from an $\alpha$-olefin such as ethylene and propylene as a main component, such as a homopolymer of propylene, a homopolymer of ethylene, and a block or random copolymer in which ethylene and other $\alpha$-olefins (e.g., propylene and buten-1) are copolymerized. One or more of these can be used to the extent that they contribute to properties of the resin material. The polyolefin-based resin used in the present invention may be linear or branched. The polyolefin-based resin is preferably at least one selected from the group consisting of a polyethylene-based resin containing a constituent unit derived from ethylene as a main component and a polypropylene-based resin containing a constituent unit derived from propylene as a main component. As the polypropylene-based resin, any of polypropylene-based resins such as isotactic, atactic, and syndiotactic polypropylenes can be also used. Examples of the polyethylene-based resin include a linear low-density polyethylene (LLDPE), a low-density polyethylene (LDPE), a high-density polyethylene (HDPE), an ultralow-density polyethylene (ULDPE), an ultrahigh-molecular weight polyethylene (UHMW-PE).

The component (A) has a melting point of, for example, 100 to 350°C, preferably 130 to 300°C, more preferably 150 to 250°C, and particularly preferably 160 to 240°C.

The water content in the component (A) is, for example, 200 ppm or less, preferably 170 ppm or less, and more preferably 150 ppm or less. The water content in the component (A) can be adjusted within the above-mentioned range, for example, by heating and drying the component (A).

[Component (B)]

In the electromagnetic wave-absorbing composition of the present invention, a Fe-Cr-Si-based soft-magnetic metal powder is contained as the component (B). The Fe-Cr-Si-based soft-magnetic metal powder is a soft-magnetic metal powder containing Fe, Si and Cr. Examples thereof include a Fe-Cr-Si-based stainless steel powder in which stainless steel such as SUS410, SUS430, and SUS434 is contained as the base material, and Si is added thereto; and a Fe-Cr-Si-based soft-magnetic metal powder with a Cr content of less than 10% by mass, such as Fe-2Cr-8Si. Among these, a Fe-Cr-Si-based stainless steel powder is preferred in terms of oxidation resistance, availability and cost, and Fe-Cr-Si-based ferritic stainless steel is more preferred. These Fe-Cr-Si-based soft-magnetic metal powders may be used alone or in combination of two or more.

Cr contained in the Fe-Cr-Si-based soft-magnetic metal powder, which is the component (B), contributes to improving corrosion resistance and electrical resistance, and improves an electromagnetic wave absorption energy. The Cr content in the Fe-Cr-Si-based soft-magnetic metal powder is preferably 1.0% by mass or more, more preferably 2.0% by mass or more, and further preferably 4.0% by mass or more. On the other hand, when the Cr content is too high, the saturation magnetization amount may decrease, the imaginary part of the relative complex permeability may decrease, and the electromagnetic wave absorption energy may decrease. Therefore, the Cr content is preferably 21.0% by mass or less.

Si contributes to improving the electrical resistance of the Fe-Cr-Si-based soft-magnetic metal powder and improves the electromagnetic wave absorption energy. When the Si content in the Fe-Cr-Si-based soft-magnetic metal powder is too low, the electrical resistance of the powder may be low, and the electromagnetic wave absorption energy may also become low. Therefore, the lower limit of the Si content is preferably 0.5% by mass. When the Si content is too high, the saturation magnetization amount may decrease, as with Cr, the imaginary part of the relative complex permeability may decrease, and the electromagnetic wave absorption energy may decrease. Therefore, the upper limit of the Si content is preferably 10% by mass.

The Fe-Cr-Si-based soft-magnetic metal powder may contain Mo. Due to the presence of Mo, the corrosion resistance and electrical resistance of the powder can be improved. As a result, the corrosion resistance of the resulting injection molded article can be improved, and the electrical resistance also increases, so that the imaginary part of the relative complex permeability further increases, and the electromagnetic wave absorption energy can be further improved. From the above viewpoint, the Mo content in the Fe-Cr-Si-based soft-magnetic metal powder is preferably 0 to 3.0% by mass.

When producing the soft-magnetic metal powder, impurities may be introduced due to the use of scrap as a raw material. The content of the impurities in the Fe-Cr-Si-based soft-magnetic metal powder is preferably 2.0% by mass or less. By allowing the content of the impurities to be within the above range, a decrease in the electromagnetic wave absorption energy can be suppressed. The impurities mean elements other than Fe, Cr, Si, and Mo, and examples of the impurities include C, N, O, and Cu.

The Fe-Cr-Si-based soft-magnetic metal powder, which is the component (B), has an average particle diameter D50 of, for example, 1 to 50 μm, preferably 1 to 15 μm, more preferably 1 to 12 μm, and further preferably 1 to 10 μm. The average particle diameter D50 in the present invention refers to the particle diameter at which the cumulative volume-based particle diameter is 50%. By adjusting the average particle diameter D50 of the component (B) to be within the above range, the electromagnetic wave absorption performance, particularly at a high frequency, becomes better.

The mass ratio of the component (A) to the component (B) (component (A)/component (B)) contained in the electromagnetic wave-absorbing composition of the present invention is from 5/95 to 80/20, preferably from 20/80 to 80/20, and more preferably from 25/75 to 75/25. By containing the component (A) and the component (B) at the above mass ratio, the electromagnetic wave absorption performance can be improved. In the electromagnetic wave-absorbing composition of the present invention, an amount to be added (addition ratio) of each of raw material components will be, as it is, a content (content ratio) in the electromagnetic wave-absorbing composition and a content (content ratio) in the molded article.

[Component (C)]

The electromagnetic wave-absorbing composition of the present invention contains, in addition to the component (A) and the component (B), a component (C) that is at least one selected from a phosphite-based compound and a phosphate-based compound. This enables the suppression of an increase in fluidity when heated while maintaining electromagnetic wave absorption performance. The component (C) used in the present invention is not particularly limited so long as it is a phosphite-based compound and/or a phosphate-based compound.

The phosphite-based compound (also called a phosphite ester compound) is a compound containing one or more phosphorus atoms with three bonds, in which s number of -OH groups, t number of $-OR^a$ groups, and u number of $-O-R^b-$groups (in the $-O-R^b-$ group, -O- is bonded to a phosphorus atom, and $R^b$ is bonded to another phosphorus atom via another -O-) are bonded to each of the phosphorus atoms, provided that s+t+u=3, t is 1 or more, and u is 0 when only one phosphorus atom is contained in one molecule of the phosphite-based compound, and u is 1 or 2 when two or more phosphorus atoms are contained in one molecule of the phosphite-based compound. When two or more phosphorus atoms are contained in one molecule, each s, each t, and each u may be different for each phosphorus atom, but are preferably the same. s is preferably 0. The number of phosphorus atoms in one molecule of the phosphite-based compound is preferably 1 to 4, more preferably 1 or 2, and particularly preferably 2.

Examples of $R^a$ include the same groups as $R^1$ to $R^3$ described later. When the phosphite-based compound contains a plurality of $R^a$s, they may be different from each other, but are preferably the same.

Examples of $R^b$ include divalent to hexavalent, preferably divalent to tetravalent, hydrocarbon groups having 1 to 20 carbon atoms, and all bonds of $R^b$ are bonded to phosphorus atoms via -O-. Examples of the hydrocarbon group represented by $R^b$ include an aliphatic hydrocarbon group, an aromatic hydrocarbon group, a group in which an aliphatic hydrocarbon group and an aromatic hydrocarbon group are combined, and a group in which two or more aromatic hydrocarbon groups are combined.

The phosphite-based compound (also called phosphite ester compound) is preferably a compound in which the above-mentioned s is 0 (which is a fully esterified compound), and more preferably at least one selected from the group consisting of compounds represented by the following formulae (C1-1) to (C1-3).

[Chemical 1]

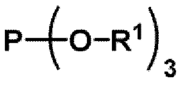
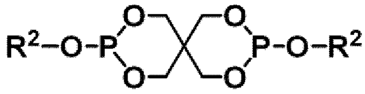
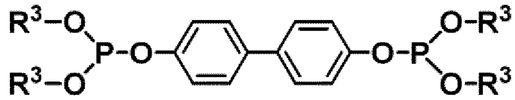

(C1-1) (C1-2) (C1-3)

In the formulae, $R^1$ to $R^3$ each represent an aliphatic hydrocarbon group having 1 to 30 carbon atoms or an aromatic hydrocarbon group having 6 to 30 carbon atoms.

In the formula (C1-1), a plurality of $R^1$s may be the same or different, but are preferably the same. In the formula (C1-2), a plurality of $R^2$s may be the same or different, but are preferably the same. In the formula (C1-3), a plurality of $R^3$s may be the same or different, but are preferably the same.

Each of the aliphatic hydrocarbon group represented by $R^1$ to $R^3$ preferably has 2 to 25 carbon atoms, more preferably 8 to 23 carbon atoms, and further preferably 12 to 20 carbon atoms.

Each of the aliphatic hydrocarbon group represented by $R^1$ to $R^3$ may be a saturated aliphatic hydrocarbon group or an unsaturated aliphatic hydrocarbon group, but is preferably a saturated aliphatic hydrocarbon group. Each of the aliphatic hydrocarbon group represented by $R^1$ to $R^3$ may be linear or branched, but is preferably linear. Examples of the aliphatic hydrocarbon group include a saturated aliphatic hydrocarbon group such as a methyl group, an ethyl group, an n-propyl group, an n-butyl group, a 2-ethylhexyl group, an n-dodecyl group, an n-tetradecyl group, an n-hexadecyl group, an n-octadecyl group, and an n-icosyl group; and an unsaturated aliphatic hydrocarbon group such as an ethenyl group, a propenyl group, a butenyl group, a dodecenyl group, a tetradecenyl group, a hexadecenyl group, an octadecenyl group, and an icosenyl group.

Each of the aromatic hydrocarbon group represented by $R^1$ to $R^3$ preferably has 6 to 25 carbon atoms, more preferably 7 to 23 carbon atoms, and further preferably 10 to 20 carbon atoms.

Examples of the aromatic hydrocarbon group represented by $R^1$ to $R^3$ include an aryl group such as a phenyl group and a naphthyl group; and an alkylaryl group where 1 to 5 alkyl groups, each having 1 to 4 carbon atoms, are bonded to an aryl group. Among them, a group where 1 to 5 alkyl groups, each having 1 to 4 carbon atoms, are bonded to a phenyl group is preferable, and a group where 1 to 3 t-butyl groups are bonded to a phenyl group is more preferable. The bonding position of the alkyl group having 1 to 4 carbon atoms (preferably the t-butyl group) that is bonded to the phenyl group is not particularly limited, but it is preferable that the alkyl group be bonded to any of the 2-position, 2,4-position, 2,6-position, or 2,4,6-position with respect to the bond to -O-P of the phenyl group.

Specific examples of the phosphite-based compound include bis(2,4-di-t-butylphenyl)pentaerythritol diphosphite, tris(2,4-di-t-butylphenyl)phosphite, bis(2,4,6-tri-t-butylphenyl)pentaerythritol diphosphite, bis(2,6-di-t-butyl-4-methylphenyl)pentaerythritol diphosphite, distearyl pentaerythritol diphosphate, and tetrakis(2,4-di-t-butylphenyl)-4,4'-biphenylene diphosphate.

The phosphate-based compound (also called a phosphoric acid ester compound) is a compound containing one or more P=O structures with three bonds on a phosphorus atom, in which the phosphorus atom of each P=O structure is bonded to s number of -OH groups, t number of $-OR^a$ groups, and u number of $-O-R^b-$ groups (in the $-O-R^b-$ groups, -O- is bonded to a phosphorus atom of P=O structure; $R^b$ is bonded to a phosphorus atom of another P=O structure via another -O-), provided that s+t+u=3, t is 1 or more, and u is 0 when only one P=O structure is contained, and u is 1 or 2 when two or more P=O structures are contained. When two or more P=O structures are contained, each s, each t, and each u may be different for each P=O structures, but are preferably the same. s is preferably 1 or 2. $R^a$ and $R^b$ are the same as mentioned above. The number of P=O structures in one molecule of the phosphate-based compound is preferably 1 or 2, and more preferably 1.

The phosphate-based compound is preferably a compound represented by the following formula (C2).

[Chemical 2]

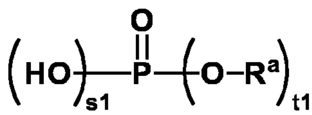

(C2)

In the formula (C2), s1 represents an integer from 0 to 2, t1 represents an integer from 1 to 3, and $R^a$ is the same as previously defined. However, s1 and t1 must satisfy the equation s1 + t1 = 3.

When the formula (C2) contains a plurality of $R^a$s, they may be either the same or different, but are preferably the same.

s1 is preferably 1 or 2.

The compound represented by the formula (C2) may be a compound in which each $R^a$ is an aromatic hydrocarbon group having 6 to 30 carbon atoms (hereinafter sometimes referred to as an aromatic phosphoric acid ester compound), or a compound in which each $R^a$ is an aliphatic hydrocarbon group having 1 to 30 carbon atoms (hereinafter sometimes referred to as an aliphatic phosphoric acid ester compound), but it is preferably an aliphatic phosphoric acid ester compound, more preferably the compound in which s1 is 1 or 2 (acid-type compound), and further preferably a compound represented by the following formula (C2-1).

[Chemical 3]

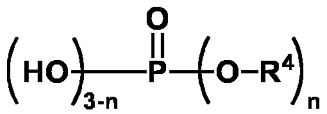

(C2-1)

In the formula (C2-1), $R^4$ represents an aliphatic hydrocarbon group having 1 to 30 carbon atoms, and n is 1 or 2.

When the formula (C2-1) contains a plurality of $R^4$s, they may be either the same or different, but are preferably the same.

The aliphatic hydrocarbon group represented by $R^4$ preferably has 1 to 25 carbon atoms, more preferably 2 to 23 carbon atoms, and further preferably 2 to 20 carbon atoms. In particular, by using the phosphate-based compound in which $R^4$ is an aliphatic hydrocarbon group having 1 to 10 carbon atoms (preferably 1 to 8 carbon atoms, more preferably 1 to 5 carbon atoms), the effect of suppressing an increase in fluidity when the composition is heated can become more excellent. The aliphatic hydrocarbon group represented by $R^4$ may have 8 to 23 carbon atoms or 12 to 20 carbon atoms. The content of the phosphate-based compound represented by the formula (C2-1) in which $R^4$ is an aliphatic hydrocarbon group having 1 to 10 carbon atoms (preferably 1 to 8 carbon atoms, more preferably 1 to 5 carbon atoms) in 100% by mass in total of the component (C) is preferably 20% by mass or more, more preferably 40% by mass or more, further preferably 50% by mass or more, and particularly preferably 80% by mass or more, and may be 100% by mass.

Examples of the aliphatic hydrocarbon group represented by $R^4$ include the same groups as those mentioned as the aliphatic hydrocarbon groups represented by $R^1$ to $R^3$. Among these, a linear aliphatic hydrocarbon group is preferable, and a linear saturated aliphatic hydrocarbon group is more preferable.

n may be 1 or 2, and a mixture of the compound in which n is 1 and the compound in which n is 2 may be used.

Specific examples of the phosphate-based compound include mono- or dimethyl acid phosphate, mono- or di-ethyl acid phosphate, mono- or di-butyl acid phosphate, mono- or di-2-ethylhexyl phosphate, mono- or di-lauryl acid phosphate, mono- or di-stearyl acid phosphate, and mono- or di-oleyl acid phosphate. These phosphate-based compounds may be used alone or in combination of two or more. The phosphate-based compound is preferably at least one selected from the group consisting of mono-ethyl acid phosphate, di-ethyl acid phosphate, mono-stearyl acid phosphate, and di-stearyl acid phosphate.

As the phosphate-based compound, commercially available products may be used, such as LBT-1830 and LBT-1813 manufactured by Sakai Chemical Industry Co., Ltd., JP-502 manufactured by Johoku Chemical Co., Ltd., and ADK STAB AX-71 manufactured by ADEKA Corporation.

As the component (C), one kind may be used alone, or two or more kinds may be used in combination.

The component (C) is preferably at least one selected from the phosphate-based compounds.

In the present invention, the content of the component (C) is 0.02 to 1.4 parts by mass, preferably 0.03 to 1.2 parts by mass, more preferably 0.03 to 1.0 part by mass, and further preferably 0.1 to 1.0 part by mass, relative to 100 parts by mass in total of the component (A) and the component (B). It can be assumed that the component (C) serves as a surface coating onto the component (B). Although the detailed mechanism of this has not yet been clarified, it is inferred that when the component (C) has a structure such as P-OH, P-OR$^a$, P-O-R$^b$-, or P=O, the component (C) is more likely to be coordinated to the surface of the component (B), making it easier to form the surface coating. It is inferred that by forming such a surface coating, the effect of improving the dispersibility of the component (B) and the effect of suppressing the deterioration behavior of the resin or elastomer due to the component (B) can be attained. If the above content is less than 0.02 parts by mass, it is difficult to obtain the desired properties. Conversely, if the above content is more than 1.4 parts by mass, the component (C) acts as a plasticizer, causing deterioration of fluidity when heated, which is not preferable.

In addition, the content of the component (C) is, for example, 0.05 to 2.0 parts by mass, preferably 0.1 to 1.5 parts by mass, more preferably 0.3 to 1.2 parts by mass, and further preferably 0.4 to 1.0 part by mass, relative to 100 parts by mass of the component (B).

The total content of the components (A), (B), and (C) in the electromagnetic wave-absorbing composition is preferably 90% by mass or more, more preferably 95% by mass or more, and further preferably 98% by mass or more, and may be 100% by mass or may be 99.5% by mass or less.

[Other Component(s)]

The electromagnetic wave-absorbing composition of the present invention may further contain an additive such as an antioxidant, a heat-resistance stabilizer, an ultraviolet absorbing agent, an antistatic agent, a dye, a pigment, a lubricating agent, a plasticizer, a mold release agent, a crystallization accelerator, a crystalline nucleating agent, and an epoxy compound, depending on the purpose. The amount of these various additives is preferably 10 parts by mass or less in total, more preferably 5 parts by mass or less in total, and further preferably 2 parts by mass or less in total, based on 100 parts by mass in total of the component (A) and the component (B).

The antioxidant is preferably a hindered phenol-based antioxidant. Specific examples thereof includes 3,5-di-t-butyl-4-hydroxytoluene, n-octadecyl-β-(4'-hydroxy-3',5'-di-t-butylphenyl)propionate, tetrakis[methylene-3-(3',5'-di-t-butyl-4'-hydroxyphenyl)propionate]methane, 1,3,5-trimethyl-2,4,6-tris(3',5'-di-t-butyl-4'-hydroxybenzyl)benzene, calcium (3,5-di-t-butyl-4-hydroxybenzyl-monoethyl-phosphate), triethylene glycol bis[3-(3-t-butyl-5-methyl-4-hydroxyphenyl) propionate], 3,9-bis[1,1-dimethyl-2-{B-(3-t-butyl-4-hydroxy-5-methylphenyl)propionyloxy}ethyl]2,4,8, 10-tetraoxaspiro [5,5]undecane, bis[3,3-bis(4'-hydroxy-3'-t-butylphenyl)butyric acidlglycol ester, 2,2'-ethylidenebis(4,6-dit-butylphenol), N,N'-bis[3-(3,5-di-t-butyl-4-hydroxyphenyl)propionyl]hydrazine, 2,2'-oxamidebis[ethyl-3-(3,5-di-t-butyl-4-hydroxyphenyl)propionate], 1,3,5-tris(3',5'-di-t-butyl-4'-hydroxybenzyl)-S-triazine-2,4,6(1H,3H,5H)-trione, 1,3,5-tris(4-t-butyl-3-hydroxy-2,6-dimethylbenzyl)isocyanurate, 3,5-di-t-butyl-4-hydroxyhydrocinnamic acid triester with-1,3,5-tris(2-hydroxyethyl)-S-triazine-2,4,6(1H,3H,5H), and N,N'-hexamethylenebis(3,5-di-t-butyl-4-hydroxybenzenepropionamide). These antioxidants may be used alone or in a mixture of two or more. The amount of the antioxidant is preferably 5 parts by mass or less, more preferably 3 parts by mass or less, and further preferably 1 part by mass or less, based on 100 parts by mass in total of the component (A) and the component (B).

Examples of the mold release agent include a long-chain fatty acid, an ester of the fatty acid, a metal salt of the fatty acid, an amide compound, a polyethylene wax, silicone, and polyethylene oxide. As the long-chain fatty acid, one having 12 or more carbon atoms is particularly preferred, and examples thereof include stearic acid, 12-hydroxystearic acid, behenic acid, and montanic acid. A part or the whole of carboxylic acid in the long-chain fatty acid may be esterified with monoglycol or polyglycol, or may form a metal salt. Examples of the amide compound include ethylene bis-terephthalamide and methylene bis-stearylamide. These mold release agents may be used alone or in a mixture of two or more. The amount of the mold release agent is preferably 5 parts by mass or less, more preferably 3 parts by mass or less, and further preferably 1 part by mass or less, based on 100 parts by mass in total of the component (A) and the component (B).

The electromagnetic wave-absorbing composition of the present invention does not usually contain any components other than those mentioned above, but may contain them as necessary. Examples of the component include a thermosetting resin and a fiber component such as a glass fiber. For example, the thermosetting resin may be contained in an amount of 0.2% by mass or less in the electromagnetic wave-absorbing composition of the present invention, and the fiber component may be contained in an amount of 4% by mass or less in the electromagnetic wave-absorbing composition of the present invention.

The method for producing the electromagnetic wave-absorbing composition of the present invention is not particularly limited, but for example, the composition can be obtained by dry-blending the components (A), (B), and (C) as well as other component(s) used as necessary, and then melt-kneading the mixture with a single- or twin-screw melt kneader, or a typical mixer for thermoplastic resin, such as a kneading heater. Thereafter, if necessary, the resulting mixture may be subjected to a granulation step to prepare pellets. Furthermore, if necessary, the component (B) may be treated (mixed) with the component (C) in advance and then mixed with the component (A).

The electromagnetic wave-absorbing composition of the present invention exhibits excellent mass productivity because it suppresses a decrease in fluidity when heating. The ΔMFR of the electromagnetic wave-absorbing composition of the present invention, determined by the following formula as measured in accordance with ISO 1133, is preferably 50 g/10 min or less, more preferably 40 g/10 min or less, even more preferably 30 g/10 min or less, and may further be 20 g/10 min or less or even 10 g/10 min or less. The lower limit of the ΔMFR of the electromagnetic wave-absorbing composition of the present invention is not particularly limited, but it may be 1 g/10 min or more.

$$\Delta MFR = (\text{MFR in retention for 20 minutes}) - (\text{MFR in retention for 5 minutes})$$

In the formula, the MFR in retention for 20 minutes is a melt flow rate measured with a preheating time of 20 minutes, and the MFR in retention for 5 minutes is a melt flow rate measured with a preheating time of 5 minutes. The melt flow rate is measured under a load of 2160 g and at a temperature higher by 25°C than a melting point of the component (A).

When the electromagnetic wave-absorbing composition contains two or more components (A) having different melting points, the temperature higher by 25°C than the melting point of the component (A) having the highest melting point may be adopted as the above measurement temperature.

When producing a molded article from the electromagnetic wave-absorbing composition of the present invention, a molding method of the composition is not particularly limited, and injection molding, extrusion molding, press molding, blow molding, and the like can be performed. Injection molding is preferred because of a high degree of freedom in shape of a molded article obtained. The electromagnetic wave-absorbing composition of the present invention easily exhibits excellent effect of suppressing an increase in fluidity when heated, particularly in injection molding. Therefore, it is preferable to subject the composition to injection molding.

The molded article produced from the composition of the present invention contains the component (A) and the component (B) at a mass ratio (component (A)/component (B)) in the range of 5/95 to 80/20, further contains the component (C) in an amount of 0.02 to 1.4 parts by mass relative to 100 parts by mass in total of the component (A) and the component (B), and has an electromagnetic wave absorption energy P, as shown in equation (1) below, at 79 GHz of 5 $kW/m^3$ or more. The molded article may also contain, as other component(s), the additive described above. The preferred types and amounts of each component contained in the molded article are the same as those mentioned above.

As described above, the electromagnetic wave-absorbing composition of the present invention is preferably subjected to injection molding, that is, a molded article produced from the composition of the present invention preferably has a gate mark. The "gate mark" means a mark such as a concave or convex portion formed due to a gate for injecting the composition when the molded article is produced by injection molding.

The shape of the molded article is not particularly limited, and the molded article can be formed into a shape (flat plate, case, etc.), a thickness, and a size according to the application. The thickness of the molded article is, for example, 0.1 to 10 mm, preferably 0.3 to 5 mm.

Regarding the absorption of electromagnetic waves by means of a substance, the electromagnetic wave absorption energy P is expressed by the following equation (1).

[Mathematical 2]

$$P = \pi f \mu_0 \mu_r{}'' |H|^2 + \pi f \varepsilon_0 \varepsilon_r{}'' |E|^2 + \frac{1}{2\rho} |E|^2 \qquad (1)$$

In the equation (1), P represents an electromagnetic wave absorption energy ($W/m^3$), $\mu_0$ represents a magnetic permeability of vacuum (H/m), $\mu_r$" represents a loss term of a relative complex permeability, $\varepsilon_0$ represents a permittivity of vacuum (F/m), $\varepsilon_r$" represents a loss term of a relative complex permittivity, p represents a resistivity (Ωm), H represents a magnetic field strength (A/m), E represents an electric field strength (V/m), and f represents a frequency (Hz).

On the right side of the equation (1), the first term represents a magnetic loss, the second term represents a dielectric loss, and the third term represents a resistance loss.

The relative complex permeability $\mu_r$ and the relative complex permittivity $\varepsilon_r$ can be calculated as follows. That is, the S-parameter of a sample is measured using a network analyzer according to the Nicolson-Ross-Weir method (see IEC TR 63307), and the relative complex permeability ($\mu_r$=$\mu_r$'-j$\mu_r$") and the relative complex permittivity ($\varepsilon_r$=$\varepsilon_r$'-j$\varepsilon_r$") can be calculated from the obtained S-parameter using the Nicolson-Ross-Weir equation. By substituting the values thus obtained into the equation (1), the electromagnetic wave absorption energy P can be determined.

The complex permeability μ [H/m] and the complex permittivity ε [F/m] are expressed as follows:

[Mathematical 3]

$$\mu = \mu_0 \mu_r = \mu' - j\mu'' = \mu_0(\mu_r{}' - j\mu_r{}'') \qquad (4-1)$$

[Mathematical 4]

$$\varepsilon = \varepsilon_0 \varepsilon_r = \varepsilon' - j\varepsilon'' = \varepsilon_0(\varepsilon_r{}' - j\varepsilon_r{}'') \qquad (4-2)$$

wherein μ' and μ" are respectively a real part and an imaginary part (loss term) of a complex permeability, $\mu_r$' and $\mu_r$" are respectively a real part and an imaginary part (loss term) of a relative complex permeability, ε' and ε" are respectively a real part and an imaginary part (loss term) of a complex permittivity, and $\varepsilon_r$' and $\varepsilon_r$" are respectively a real part and an imaginary part (loss term) of a relative complex permittivity. j is an imaginary unit.

The electromagnetic wave-absorbing composition of the present invention has excellent electromagnetic wave absorption performance, and therefore can achieve an electromagnetic wave absorption energy P determined from the above equation (1) at 79 GHz of 5 $kW/m^3$ or more. The electromagnetic wave absorption energy P is preferably 15 $kW/m^3$ or more, more preferably 25 $kW/m^3$ or more, and further preferably 30 $kW/m^3$ or more. The upper limit of the electromagnetic wave absorption energy P is not particularly limited, but is, for example, 100 kW/$m^3$ or less. The electromagnetic wave absorption energy P of the electromagnetic wave-absorbing composition may be measured using a test piece having a thickness of 1 mm obtained by being molded (preferably injection-molded) of the electromagnetic wave-absorbing composition.

The above electromagnetic wave absorption energy P and ΔMFR can be measured according to the method shown in Examples described later.

The present application claims benefit of priority to Japanese Patent Application No. 2022-178676 filed on November 8, 2022. The entire contents of the specification of Japanese Patent Application No. 2022-178676 filed on November 8, 2022, are incorporated herein by reference.

EXAMPLES

Hereinafter, the present invention will be more specifically described with Examples. However, the scope of the present invention is not limited by Examples.

<Examples 1 to 13 and Comparative Examples 1 to 6>

In Examples 1 to 13 and Comparative Examples 1 to 6, the following materials were used as components of the electromagnetic wave-absorbing compositions.

[Component (A)]

A-1: Polybutylene terephthalate, melting point: 225°C, resin drying temperature: 130°C (manufactured by Toyobo Co., Ltd., inherent viscosity=0.83 dl/g)
A-2: Polybutylene terephthalate, melting point: 225°C, resin drying temperature: 130°C (manufactured by Toyobo Co., Ltd., inherent viscosity=1.32 dl/g)
A-3: Polyester elastomer, melting point: 205°C, resin drying temperature: 100°C

Copolymer having a composition ratio of PBT/HPCD=70/30 (% by mass) (PELPRENE (registered trademark) manufactured by Toyobo Co., Ltd., reduced viscosity: 1.20 dl/g, Shore D hardness: 60)

The polyester elastomer (A-3) was produced by the following method. 70 parts by mass of polybutylene terephthalate (PBT) having a number average molecular weight of 30000 and 30 parts by mass of polycarbonate diol (HPCD) having a number average molecular weight of 10000 and containing a 1,6-hexanediol residue were stirred at 225°C to 245°C under 130 Pa for 1 hour to prepare a mixture. After the ester exchange reaction had progressed and the mixture was confirmed to turn transparent, the contents were taken out and cooled to obtain a polyester elastomer (A-3).

A-4: Polyester elastomer, melting point: 180°C, resin drying temperature: 100°C

Polyester elastomer of terephthalic acid (TPA)//1,4-butanediol (BD)/polyoxytetramethylene glycol (PTMG, number average molecular weight: 2000)=100//75/25 (mol%) (reduced viscosity: 2.50 dl/g, acid value: 21 eq/ton, Shore D hardness: 31)

A-5: Polyamide 6, melting point: 225°C, resin drying temperature: 100°C (manufactured by Toyobo Co., Ltd., relative viscosity=2.2)

The above melting point, intrinsic viscosity, reduced viscosity, Shore D hardness, acid value, and relative viscosity were measured using the following methods.

<Melting Point>

The melting point was determined using a DSC220 differential scanning calorimeter produced by Seiko Instruments Inc.. A measurement sample of 5 mg was placed in an aluminum pan, sealed with a pressed lid, and heated from 20°C to 270°C at a rate of 10°C/min under a nitrogen atmosphere. The endothermic peak due to melting in the obtained thermogram curve was taken as the melting point.

<Intrinsic Viscosity>

A sample of 0.1 g was dissolved in 25 ml of a mixed solvent of phenol/tetrachloroethane (mass ratio 6/4), and the intrinsic viscosity was measured at 30°C using a Ubbelohde viscometer. (Unit: dl/g)

<Reduced Viscosity>

A sample of 0.05 g was dissolved in 25 ml of a mixed solvent of phenol/tetrachloroethane (mass ratio 60/40), and the reduced viscosity was measured at 30°C using an Ostwald viscometer. (Unit: dl/g)

<Shore D Hardness>

The Shore D hardness was measured in accordance with JIS K7215 (-1986). The test piece used was a stack of three injection-molded products (length: 100 mm, width: 100 mm, thickness: 2 mm) prepared at a cylinder temperature of 240°C and a mold temperature of 50°C. The measurement was conducted using a durometer with a type-D indenter under a measurement pressure of 5000 g. The value at 5 seconds after the start of the measurement was defined as the D hardness (Shore D hardness).

<Acid Value>

A sample of 0.5 g was dissolved in 25 ml of benzyl alcohol and titrated using a 0.01 mol/l sodium hydroxide solution in benzyl alcohol. The indicator used was 0.10 g of phenolphthalein, dissolved in a mixture of 50 mL of ethanol and 50 mL of water.

<Relative Viscosity>

A polyamide resin of 0.25 g was dissolved in 25 ml of 98% sulfuric acid. Then, 10ml of this sample solution was placed in an Oswald viscosity tube and the efflux time was measured at 20°C. Separately, the solvent (98% sulfuric acid) was also placed in an Oswald viscosity tube and the efflux time was measured at 20°C. The relative viscosity was calculated using the following formula;

$$RV = T / T0$$

wherein RV represents relative viscosity, T represents efflux time of the sample solution, and T0 represents efflux time of the solvent.

[Component (B)]

B-1: Fe-13Cr-1Si (average particle diameter D50: about 10 μm)
B-2: Fe-17Cr-2Si (average particle diameter D50: about 10 μm)
B-3: Fe-2Cr-8Si (average particle diameter D50: about 10 μm)

The average particle diameter D50 was determined as follows. Ethanol and a powder sample were put in a beaker and then subjected to dispersion treatment for 30 seconds with an ultrasonic cleaner. The dispersed sample was placed in a chamber of a sample circulating unit of a laser diffraction/scattering type particle size distribution analyzer MT3300EXII (manufactured by MicrotracBEL Corporation), and the volume distribution was measured for a measurement time of 120 seconds. A particle diameter at 50% in the measured volume distribution was defined as the average particle diameter D50.

[Component (C)]

C-1: "JP-502" manufactured by Johoku Chemical Co., Ltd.

C-2: "ADK STAB AX-71" manufactured by ADEKA Corporation

[Other Additives]

Antioxidant: IRGANOX1010, manufactured by BASF Corporation
Mold release agent: LICOWAX-OP, manufactured by Clariant Corporation

Components shown in Table 1 were dry-blended at a ratio of contents (parts by mass) shown in Table 1, and melt-kneaded using a twin-screw extruder (STS-35, manufactured by COPERION Corporation) under the conditions of a cylinder temperature set to a temperature higher by 25°C than the melting point of each component (A), a discharge rate of 20 kg/hr, and a screw rotation speed of 180 rpm to prepare pellets of an electromagnetic wave-absorbing composition. The pellets obtained were used to measure ΔMFR by the method described below. Furthermore, the pellets obtained were used to prepare test pieces by the method described below, and the electromagnetic wave absorption energy P at 79 GHz of the electromagnetic wave-absorbing composition was measured. The measurement results of the electromagnetic wave-absorbing compositions of Examples 1 to 13 and Comparative Examples 1 to 6 are shown in Table 1.

<Electromagnetic Wave Absorption Energy P at 79 GHz>

In order to calculate the electromagnetic wave absorption energy P, the preparation (molding) and measurement of test pieces were performed in the following procedure.

Using an injection molding machine manufactured by Toshiba Machine Co., Ltd., a flat plate having a size of 100 mm×100 mm×1 mm (thickness) was molded by injection molding at a cylinder temperature set to a temperature higher by 25°C than the melting point of each component (A) and a mold temperature set to 50°C. The flat plate was processed into a size that allowed insertion into a sample holder used in the Nicolson-Ross-Weir method (see IEC TR 63307) described below to prepare a test piece.

The electromagnetic wave absorption energy P was calculated from the following equation (1).

[Mathematical 5]

$$P = \pi f \mu_0 \mu_r'' |H|^2 + \pi f \varepsilon_0 \varepsilon_r'' |E|^2 + \frac{1}{2\rho} |E|^2 \qquad (1)$$

In the equation (1), P represents an electromagnetic wave absorption energy ($W/m^3$), $\mu_0$ represents a magnetic permeability of vacuum (H/m), $\mu_r''$ represents a loss term of a relative complex permeability, $\varepsilon_0$ represents a permittivity of vacuum (F/m), $\varepsilon_r''$ represents a loss term of a relative complex permittivity, p represents a resistivity (Ωm), H represents a magnetic field strength (A/m), E represents an electric field strength (V/m), and f represents a frequency (Hz).

The parameters were measured as follows. An N5261A millimeter wave controller (manufactured by Keysight Technologies, Inc.) was connected to an N5227A network analyzer (manufactured by Keysight Technologies, Inc), and a test piece (thickness: 1 mm) of each of Examples 1 to 13 and Comparative Examples 1 to 6 was inserted into a sample holder, and an S-parameter was measured according to the Nicolson-Ross-Weir method (see IEC TR 63307).

A relative complex permeability ($\mu_r=\mu_r'-j\mu_r''$) and a relative complex permittivity ($\varepsilon_r=\varepsilon_r'-j\varepsilon_r''$) were calculated from the measured S-parameter by substitution into the Nicolson-Ross-Weir equation (see IEC TR 63307). In the equation (1), the calculation was performed with |H|=1 [A/m], |E|=1 [V/m], and $\rho=1\times10^7$ [Ωm].

<Degree of Increase in Fluidity When Heated (ΔMFR)>

The degree of increase in fluidity when the electromagnetic wave-absorbing composition was heated was evaluated based on the measurement results of melt flow rates measured with different preheating times. In the following evaluation, the preheating time is regarded as the heating time of the electromagnetic wave-absorbing composition.

Using a melt indexer (manufactured by Toyo Seiki Seisaku-sho, Ltd.), pellets with a moisture content adjusted to 200 ppm or less by drying for 3 hours at a predetermined resin drying temperature appropriate for each component (A) were used to measure a MFR in retention for 20 minutes and a MFR in retention for 5 minutes under a load of 2160 g in accordance with ISO 1133. The test temperature was a temperature higher by 25°C than the melting point of each component (A) (250°C in the case of polybutylene terephthalate resins A-1 and A-2, 230°C in the case of polyester elastomer resin A-3, 205°C in the case of polyester elastomer resin A-4, and 250°C in the case of polyamide resin A-5). The

measurement results were substituted into the following formula to determine ΔMFR.

ΔMFR = (MFR in retention for 20 minutes) - (MFR in retention for 5 minutes)

In the formula, the MFR in retention for 20 minutes is a melt flow rate measured in accordance with ISO 1133 with a preheating time of 20 minutes, and the MFR in retention for 5 minutes is a melt flow rate measured in accordance with ISO 1133 with a preheating time of 5 minutes.

[Table 1]

| | | | Examples | | | | | | | | | | | | | Comparative Examples | | | | | |
|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 1 | 2 | 3 | 4 | 5 | 6 |
| Composition | (A-1) Polybutylene terephthalate | parts by mass | 29 | 75 | 50 | 29 | 29 | | | | | 29 | 29 | 29 | 29 | 29 | 50 | | 29 | 29 | 29 |
| | (A-2) Polybutylene terephthalate | parts by mass | | | | | | 29 | | | | | | | | | | | | | |
| | (A-3) Polyester elastomer | parts by mass | | | | | | | 25 | | | | | | | | | 25 | | | |
| | (A-4) Polyester elastomer | parts by mass | | | | | | | | 28 | | | | | | | | | | | |
| | (A-5) Polyamide 6 | parts by mass | | | | | | | | | 27 | | | | | | | | | | |
| | (B-1) Fe-13Cr-1Si | parts by mass | 71 | 25 | 50 | 71 | 71 | 71 | 75 | 72 | 73 | 71 | 71 | | | 71 | 50 | 75 | 71 | 71 | 71 |
| | (B-2) Fe-17Cr-2Si | parts by mass | | | | | | | | | | | | 71 | | | | | | | |
| | (B-3) Fe-2Cr-8Si | parts by mass | | | | | | | | | | | | | 71 | | | | | | |
| | (C-1) Phosphate-based compound | parts by mass | 0.4 | 0.2 | 0.4 | 0.8 | 0.05 | 0.4 | 0.4 | 0.1 | 0.1 | 0.2 | | 0.4 | 0.4 | | | | 0.01 | | 1.5 |
| | (C-2) Phosphate-based compound | parts by mass | | | | | | | | | | 0.2 | 0.4 | | | | | | | 0.01 | |
| | Antioxidant | parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Mold release agent | parts by mass | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 |

(continued)

| | | | Examples | | | | | | | | | | | | | Comparative Examples | | | | | |
|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 1 | 2 | 3 | 4 | 5 | 6 |
| Content of component (C) relative to 100 parts by mass of component (B) | | parts by mass | 0.56 | 0.8 | 0.8 | 1.13 | 0.07 | 0.56 | 0.53 | 0.14 | 0.14 | 0.56 | 0.56 | 0.56 | 0.56 | 0 | 0 | 0 | 0.01 | 0.01 | 2.11 |
| Evaluation | Electromagnetic wave absorption energy P at 79 GHz | $kW/m^3$ | 34 | 7 | 20 | 34 | 34 | 34 | 33 | 33 | 34 | 34 | 34 | 35 | 37 | 34 | 20 | 33 | 34 | 34 | 34 |
| | $\Delta$MFR | g/10min | 21 | 20 | 24 | 35 | 27 | 30 | 9 | 17 | 3 | 25 | 27 | 24 | 18 | 105 | 80 | 102 | 70 | 71 | 80 |

As is clear from Table 1, the electromagnetic wave-absorbing compositions of Examples 1 to 13 of the present invention maintained good electromagnetic wave absorption performance while an increase in fluidity when heated was suppressed by mixing the thermoplastic resin or thermoplastic elastomer as the component (A) with the Fe-Cr-Si-based soft-magnetic metal powder as the component (B) and at least one selected from the phosphite-based compound and the phosphate-based compound as the component (C) in a specified range of ratios. On the other hand, Comparative Examples 1 to 6 in which the component (C) was not used or the content of the component (C) fell outside the specific range had a significant increase in fluidity when heated, and there is concern about a detrimental effect on mass productivity.

INDUSTRIAL APPLICABILITY

According to the present invention, it is possible to obtain a resin- or elastomer-containing composition that can suppress an increase in fluidity when heated and has excellent electromagnetic wave absorption performance. Therefore, it is expected that components in which electromagnetic wave noise may become a problem can be manufactured with high production efficiency. In particular, a millimeter-wave radar, which is increasingly being installed in automobiles to ensure safety while driving, has high speed and highly accurate detection capabilities using an electromagnetic wave of 79 GHz, but malfunctions due to noise are a major safety problem, and measures to address this problem are essential. Thus, by applying the electromagnetic wave-absorbing composition of the present invention, weight reduction due to replacement for metals and the like and improvement in the degree of freedom in shape can be expected. Furthermore, by applying the electromagnetic wave-absorbing composition of the present invention, it is possible to impart electromagnetic wave absorption performance to casing materials that normally do not have an antinoise function. Therefore, the electromagnetic wave-absorbing composition of the present invention is a remarkable material that makes it possible to create components with greater safety.

## Claims

1. An electromagnetic wave-absorbing composition comprising a component (A) that is at least one selected from a thermoplastic resin and a thermoplastic elastomer and a component (B) that is a Fe-Cr-Si-based soft-magnetic metal powder at a mass ratio (component (A)/component (B)) in a range of 5/95 to 80/20, and further comprising a component (C) that is at least one selected from a phosphite-based compound and a phosphate-based compound in an amount of 0.02 to 1.4 parts by mass relative to 100 parts by mass in total of the component (A) and the component (B),
wherein the electromagnetic wave-absorbing composition has an electromagnetic wave absorption energy P, shown in the following equation (1), at 79 GHz of 5 kW/$m^3$ or more:
[Mathematical 1]

$$P = \pi f \mu_0 \mu_r'' |H|^2 + \pi f \varepsilon_0 \varepsilon_r'' |E|^2 + \frac{1}{2\rho} |E|^2 \qquad (1)$$

wherein P represents an electromagnetic wave absorption energy (W/$m^3$), $\mu_0$ represents a magnetic permeability of vacuum (H/m), $\mu_r''$ represents a loss term of a relative complex permeability, $\varepsilon_0$ represents a permittivity of vacuum (F/m), $\varepsilon_r''$ represents a loss term of a relative complex permittivity, p represents a resistivity (Ωm), H represents a magnetic field strength (A/m), E represents an electric field strength (V/m), and f represents a frequency (Hz).

2. The electromagnetic wave-absorbing composition according to claim 1, wherein ΔMFR determined by the following formula as measured in accordance with ISO 1133 is 50 g/10 min or less:

ΔMFR = (MFR in retention for 20 minutes) - (MFR in retention for 5 minutes)

wherein the MFR in retention for 20 minutes is a melt flow rate measured with a preheating time of 20 minutes, and the MFR in retention for 5 minutes is a melt flow rate measured with a preheating time of 5 minutes; and the melt flow rate is measured under a load of 2160 g and at a temperature higher by 25°C than a melting point of the component (A).

3. The electromagnetic wave-absorbing composition according to claim 1 or 2, wherein the component (A) comprises at least one selected from the group consisting of a polyester-based resin, a polyester elastomer, a polycarbonate-based resin, a polyamide-based resin, a polyphenylene sulfide-based resin, and a polyolefin-based resin.

**4.** The electromagnetic wave-absorbing composition according to claim 1 or 2, wherein the component (B) contains 1.0 to 21.0% by mass of Cr, 0.5 to 10.0% by mass of Si, and 0 to 3.0% by mass of Mo with the balance being Fe and impurities.

**5.** The electromagnetic wave-absorbing composition according to claim 1 or 2, wherein the component (B) has an average particle diameter D50 of 3 to 15 μm.

**6.** A molded article formed from the electromagnetic wave-absorbing composition according to claim 1 or 2.

**INTERNATIONAL SEARCH REPORT**

International application No.
**PCT/JP2023/039490**

**A. CLASSIFICATION OF SUBJECT MATTER**

***C08L 101/00***(2006.01)i; ***B22F 1/00***(2022.01)i; ***B22F 1/052***(2022.01)i; ***B22F 3/00***(2021.01)i; ***C01B 33/06***(2006.01)i; ***C08J 5/18***(2006.01)i; ***C08K 3/08***(2006.01)i; ***C08K 5/521***(2006.01)i; ***C08K 5/524***(2006.01)i; ***C22C 38/00***(2006.01)i
FI: C08L101/00; C08K3/08; C08K5/524; C08K5/521; C01B33/06; B22F1/00 Y; B22F1/052; C22C38/00 303S; B22F3/00 B; C08J5/18 CFD

According to International Patent Classification (IPC) or to both national classification and IPC

**B. FIELDS SEARCHED**

Minimum documentation searched (classification system followed by classification symbols)

C08L101/00; B22F1/00; B22F1/052; B22F3/00; C01B33/06; C08J5/18; C08K3/08; C08K5/521; C08K5/524; C22C38/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2007/013436 A1 (SONY CHEMICAL & INFORMATION DEVICE CORP.) 01 February 2007 (2007-02-01)<br>paragraph [0101], table 5, comparative example 6B | 1-3, 6<br>4, 5 |
| A | JP 2022-16388 A (TOYO INK SC HOLDINGS CO., LTD.) 21 January 2022 (2022-01-21) | 1-6 |
| A | JP 2007-169417 A (KURODA DENKI KK) 05 July 2007 (2007-07-05) | 1-6 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 December 2023** | **26 December 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/039490**

| Patent document cited in search report | Publication date (day/month/year) | Patent family member(s) | Publication date (day/month/year) |
|---|---|---|---|
| WO 2007/013436 A1 | 01 February 2007 | TW 200731299 A | |
| JP 2022-16388 A | 21 January 2022 | WO 2022/009956 A1<br>EP 4180485 A1<br>TW 202203264 A<br>KR 10-2023-0037548 A<br>CN 115943468 A | |
| JP 2007-169417 A | 05 July 2007 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002164687 A
- JP 6859652 B
- JP 2012151205 A
- JP 502 A
- JP 2022178676 A